# EUROPEAN PATENT APPLICATION

(11) **EP 1 837 901 A1**
(43) Date of publication of application: **26.09.2007**
(21) Application number: 05809744.5
(22) Date of filing: 25.11.2005
(51) Int. Cl.: H01L 21/304, B24B 37/00, C09K 3/14

(54) **PROCESS FOR PRODUCING ABRASIVE MATERIAL, ABRASIVE MATERIAL PRODUCED BY THE SAME, AND PROCESS FOR PRODUCING SILICON WAFER**

(30) Priority: 01.12.2004 JP 2004348171
(71) Applicant: SHIN-ETSU HANDOTAI COMPANY LIMITED, Chiyoda-ku Tokyo 100-0005 (JP)
(72) Inventor: NAKAMURA, Mikio Nagano Denshi Co., Ltd.,, Chikuma-shi, Nagano 387-8555 (JP); KIDA, Takahiro Nagano Denshi Co., Ltd.,, Chikuma-shi, Nagano 387-8555 (JP); TAKANO, Tomofumi Nagano Denshi Co., Ltd.,, Chikuma-shi, Nagano 387-8555 (JP); IMAI, Toshihiko Shin-Etsu Handotai Co. Ltd.,, Nishishirakawa-gun,Fukushima 961-8061 (JP); OHSHIMA, Masaaki, Chiba-shi, Chiba 260-0027 (JP)
(74) Representative: Wibbelmann, Jobst
(86) International application number: PCT/JP2005/021646
(87) International publication number: WO 2006/059537

(57) **Abstract**

The present invention is a method for producing a polishing agent in which silica particles are dispersed in an aqueous solution, comprising at least a step of removing metal compound ions from a prepared silica sol by ion exchange (B); a step of purifying further the ion-exchanged silica sol (D); a step of adding alkali metal hydroxide to the purified silica sol (F); and a step of adding an acid to the silica sol to which the alkali metal hydroxide is added (G). There is provided a method for producing a polishing agent which can extremely effectively suppress metal contamination when a silicon wafer or the like is polished can be produced.

## Description

### Technical Field

The present invention relates mainly to a method for producing a polishing agent, particularly a method for producing a polishing agent suitable for polishing a silicon wafer.

### Background Art

Semiconductor wafers used for manufacturing semiconductor devices are produced through various steps. For example, when a silicon wafer is produced, a silicon single crystal ingot grown by Czochralski method or the like is sliced and processed into a disk-shaped wafer (slicing step). Subsequently, a peripheral edge portion of the wafer is chamfered in order to prevent breaking or cracking (chamfering step), then lapping is carried out in order to flatten a surface of the wafer (flattening step). There are some cases where surface grinding is carried out instead of lapping. Then, etching is carried out in order to remove mechanical damages and the like left on the surface of the wafer (etching step).

Moreover, surface polishing is carried out in order that the surface of the wafer is flattened further and made a mirror surface at the same time (polishing step). Thereafter, contaminants such as a polishing agent and a foreign body attaching to the surface of the wafer during the polishing are removed using a cleaning solution containing hydrogen peroxide and the like (SC-1, SC-2 and so on) (cleaning step). Lastly a silicon wafer produced after these steps is subjected to a quality examination and the like, then put in a dedicated container and packaged, then shipped to a device maker (device manufacturing process).

There are some cases where steps of heat treatment and the like are added to the above steps, the order of the steps is changed, or the same step is carried out with it divided into plural steps.

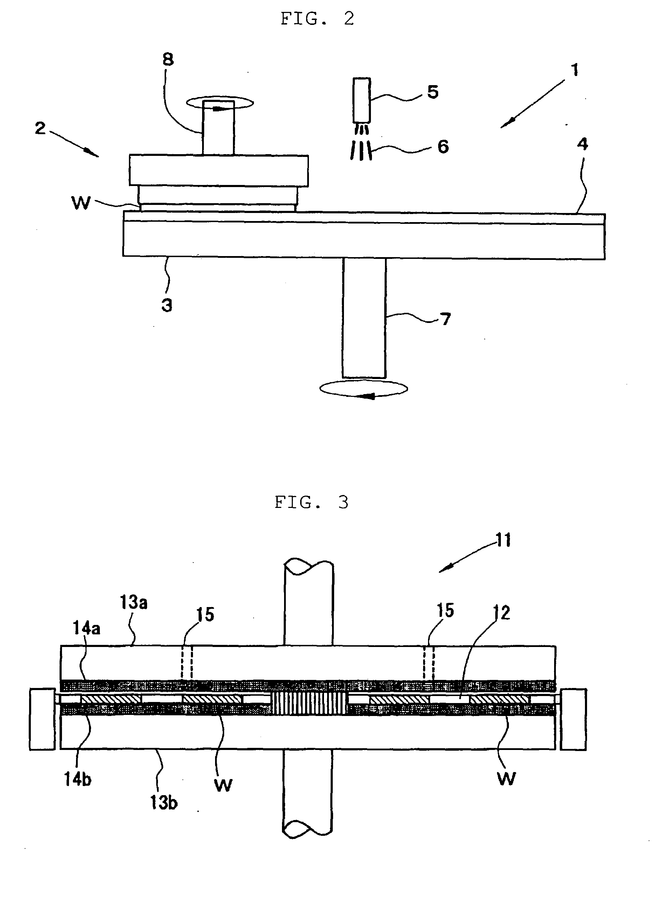

In the polishing step, a wafer is polished using, for example, a polishing apparatus 1 shown in Fig. 2. In this apparatus 1, a wafer W is held with polishing head (holding plate) 2, then contacted with a polishing pad 4 attached to a polishing turn table 3 with a given pressure and polished. On this occasion, the polishing pad 4 is provided with a polishing agent 6 through a nozzle 5 while the polishing head 2 and a polishing turn table 3 are respectively rotated on rotation axes 8 and 7. In polishing a silicon wafer, a polishing agent in a state of suspension (also called a slurry) is generally used, wherein an alkaline solution is added to a colloidal silica (a silica sol) in which fine-particle silica (SiO₂) is suspended in pure water. On the ground that such a polishing agent intervenes between a polishing pad and a silicon wafer, mechanochemical effects are brought about on the polishing agent and the wafer and polishing is promoted. Additionally, there are some cases where the polishing step is divided into the first polishing step in which a relatively rough polishing is carried out and a final polishing step in which more precise polishing is carried out, or according to circumstances, the polishing step is divided into three or more steps such as the first step, the second step and a final step.

Recently, as a device becomes finer, higher quality for a semiconductor wafer is demanded. Preventing metal contamination as possible along with finishing a wafer surface in high flatness is required. For example, a Cu concentration of a polished wafer is required to be a level of 1E + 10 atoms/cm² or less. Therefore, in the polishing step, it is necessary to use a polishing agent containing as few metal impurities as possible.

As a method for producing a silica sol used for a polishing agent, there is a method in which metal impurities are removed by ion exchange and the like to improve the purity (see Japanese Patent Application Laid-opens (kokai) Nos. 5-97422 and 6-16414). For example, there is disclosed a method for producing an aqueous silica sol containing substantially no metal impurities (metal oxides) in which an aqueous solution of alkali metal silicate is contacted with a cation exchange resin; subsequently a strong acid is added, ion exchange is carried out, alkali metal hydroxide is added and so on to provide an aqueous silica sol; then ion exchange is carried out and ammonia is added to produce an aqueous silica sol containing substantially no metal impurities (metal oxides) (see Japanese Patent Application Laid-open (kokai) No. 5-97422).

Moreover, as a polishing agent used for polishing a surface of a semiconductor wafer such as a silicon wafer, there is disclosed a polishing agent containing silica particles coated with aluminum or alumina. It is said that a colloidal silica containing silica particles coated with aluminum has high stability in a strong alkaline solution (see Japanese Patent Application Laid-open (kokai) No. 11-302635).

Recently, a silica sol coated with alumina is widely used. To produce a polishing agent containing such an alumina-coated silica sol, generally, a sodium aluminate sol is mixed with a silica sol purified by ion exchange and the like, then heat sterilization treatment is carried out. Thereby silica particles are alumina-coated to provide a polishing agent having an outstanding dispersibility.

However, there has been a problem that in the case where a silicon wafer is polished using the polishing agent produced through the steps such as ion exchange and alumina-coating as described above, a concentration of metal impurities such as Cu in the bulk of a wafer becomes high and the recent demand for quality of device manufacturing cannot be satisfied.

### Disclosure of the Invention

The present invention was conceived in view of the above problem. The main object of the present invention is to provide a method for producing a polishing agent which can extremely effectively suppress metal contamination when a silicon wafer or the like is polished.

To achieve the above-mentioned object, according to the present invention, there is provided a method for producing a polishing agent in which silica particles are dispersed in an aqueous solution, comprising at least a step of removing metal compound ions from a silica sol by ion exchange; a step of purifying further the ion-exchanged silica sol; a step of adding alkali metal hydroxide to the purified silica sol; and a step of adding an acid to the silica sol to which the alkali metal hydroxide is added.

As described above, when a polishing agent is produced after an aqueous solution in which silica particles are dispersed is ion exchanged, purified further, added alkali metal hydroxide, and added an acid in that order, metal ions such as Cu attaching to the peripheries of silica particles can be effectively removed, so that a polishing agent having extremely high purity can be produced.

It is preferable that a strong acid is used as the acid.

In particular, when a strong acid such as sulfuric acid, nitric acid or hydrochloric acid is used, there can be produced a polishing agent to which an effect of suppressing metal contamination such as Cu is added.

It is preferable that after the alkali metal hydroxide is added, quaternary ammonium salt is added either together with the acid, or before or after the acid is added. Particularly, it is preferable that tetramethylammonium hydroxide is used as the quaternary ammonium salt.

As described above, when quaternary ammonium salt, particularly tetramethylammonium hydroxide (TMAH) is added, agglomeration of silica particles can be sufficiently prevented and a stable polishing agent which has an outstanding dispersibility as well as high purity.

Furthermore, after the alkali metal hydroxide is added, an organic chelating agent can be added either together with the acid, or before or after the acid is added. Particularly, it is preferable that at least one selected from the group consisting of polyamino-polycarboxylic acid derivatives and salts of polyamino-polycarboxylic acid derivatives is used as the organic chelating agent.

As described above, when the organic chelating agent, particularly polyamino-polycarboxylic acid derivatives or salt of polyamino-polycarboxylic acid derivatives is added, metal ions such as Cu in a polishing agent can be captured, and there can be provided a polishing agent to which even higher effect of suppressing metal contamination of a silicon wafer or the like is added.

Ion exchange can be carried out as the step of purifying.

Namely, when a silica sol is subjected to ion exchange again after the first ion exchange, metal ions and so on left in the silica sol can be even more surely removed, and the silica sol can be purified further.

It is preferable that an alkaline silica sol having a pH in the range of 8 to 13 is used as the prepared silica sol, moreover, it is preferable that a silica sol containing spherical-silica particles having an average particle size in the range of 11 to 13 nm is used as the prepared silica sol.

When such a silica sol as described above is used, a polishing agent suitable particularly for polishing a silicon wafer is easy to be produced.

Moreover, it is preferable that after the ion exchange is carried out, the silica sol has a pH in the range of 2 to 4, and it is preferable that the silica sol after the acid is added has a pH in the range of 10 to 12.

When a pH is adjusted as described above in each step, a silica sol having more preferred mechanochemical effects on a silicon wafer can be surely produced.

Furthermore, according to the present invention, there is provided a polishing agent produced by the method described above.

A polishing agent produced by the method in the present invention has extremely low concentration of metal impurities such as Cu attaching to surfaces of silica particles, so that it is suitable particularly for polishing a semiconductor wafer such as a silicon wafer.

Moreover, according to the present invention, there is provided a method for producing a silicon wafer comprising at least a polishing step, wherein as the polishing step, the wafer is polished by contacting and rubbing with a polishing pad with providing the polishing agent produced by the above-described method to the polishing pad.

When a silicon wafer is polished using a polishing agent produced by the method in the present invention, there are extremely few metal impurities such as Cu attaching to surfaces of silica particles, therefore, there can be produced a mirror wafer which satisfies the recent demand for quality of device manufacturing.

According to the present invention, metal ions such as Cu attaching to the peripheries of silica particles are effectively removed, so that there can be produced a polishing agent having extremely high purity. Therefore, when a silicon wafer or the like is polished using the polishing agent, metal contamination of the wafer due to the polishing agent can be effectively suppressed and there can be provided a mirror wafer of high quality.

### Brief Explanation of the Drawings

Fig. 1 is a flow chart showing an example of a method for producing a polishing agent according to the present invention.
Fig. 2 is a schematic view showing an example of a single-side polishing apparatus.
Fig. 3 is a schematic view showing an example of a double-side polishing apparatus.
Fig. 4 is a graph showing a Cu concentration of a silicon wafer after having been polished in Example 1 and Comparative Example 1.
Fig. 5 is a graph showing a Cu concentration of a silicon wafer after having been polished in Examples 1 and 2.
Fig. 6 is a graph showing a polishing rate of a polishing agent of Examples 3, 4 and Comparative Example 1.
Fig. 7 is a graph showing the number of defects on a surface of a silicon wafer after having been polished with a polishing agent of Examples 3, 4 and Comparative Example 1.
Fig. 8 is a graph showing a Cu concentration of a silicon wafer after having been polished with a polishing agent of Examples 3, 4 and Comparative Example 1.

### Best Mode for Carrying out the Invention

Hereinafter, a method for producing a polishing agent and a method for polishing a silicon wafer using the polishing agent produced thereby will be explained specifically.

The present inventors have studied a polishing agent for a silicon wafer.

When a silicon wafer is polished using a polishing agent containing a colloidal silica, there are some cases where the wafer is metal contaminated by metal impurities contained in the polishing agent. It is considered to be a cause for this kind of metal contamination that metal impurities such as Cu present on surfaces of silica particles are diffused in the wafer due to heat generation during polishing and other factors, and taken into the bulk.

Then, in order to remove metal impurities such as Cu contained in a colloidal silica, it is considered to change a producing method and so on of silica particles themselves to improve the purity. However, when the purity is attempted to be improved in this way, shapes of silica particles change into distorted shapes, and when a silicon wafer is polished using a polishing agent containing the distorted silica particles, an extraordinary high incidence of LPDs (Light Point Defects, a general term for defects measured by light scattering method) is brought about in the wafer after being polished.

The present inventors have studied further, and as a result, they have found that in producing a polishing agent, metal impurities such as Cu attaching to surfaces of silica particles can be effectively removed to produce a polishing agent of high quality having no distorted silica particles, when a silica sol is purified by ion exchange and the like to some extent, subsequently an acid is added at the final stage without conventional addition of sodium aluminate and a subsequent heat sterilization treatment, then, they have completed the present invention.

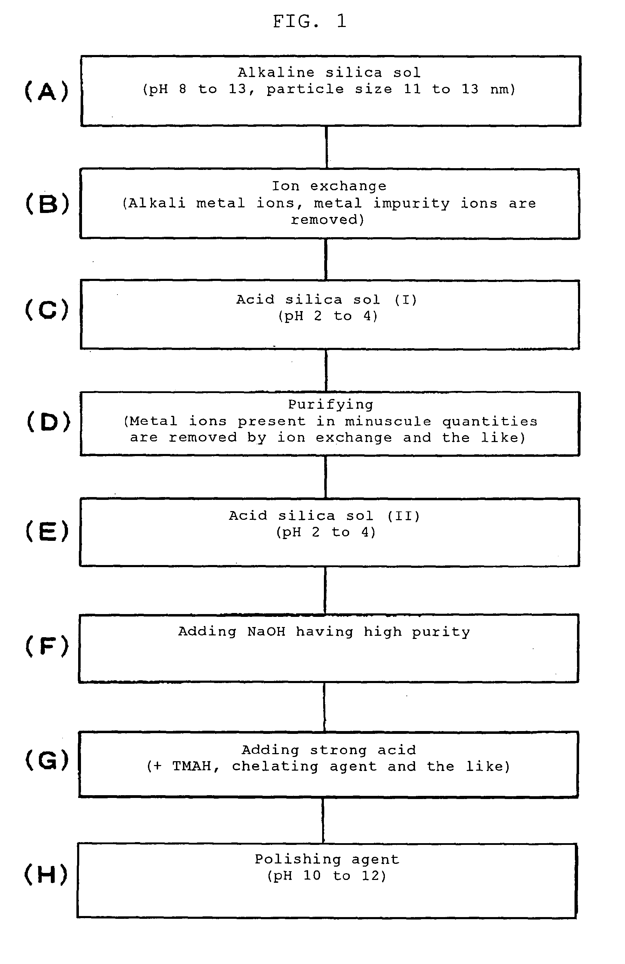

Fig. 1 is a flow chart showing an example of a method for producing a polishing agent according to the present invention. When a polishing agent is produced according to the present invention, firstly a silica sol is prepared (Fig. 1(A)). In order to make the silica sol a polishing agent that provides enhanced mechanochemical effects, it is preferable that the silica sol is alkaline with a pH in the range of 8 to 13, and an average particle size of silica particles contained in the silica sol is in the range of 11 to 13 nm. Such a silica sol can be obtained in a market or manufactured, for example, by the following method known to the public.

An aqueous solution of sodium silicate containing silica (SiO₂) by 1 to 6% by weight is subjected to a sodium removal treatment. For example, by letting the aqueous solution of sodium silicate through a column packed with a cation exchange resin in hydrogen form, metal ions such as sodium ions can be removed. Thereby, an aqueous solution of activated silica from which alkali metal ions are particularly removed can be obtained. It is preferable that a particle size of the silica particles at this stage is about 1 to 5 nm, particularly about 2 nm.

After the sodium removal treatment is carried out as described above, alkali metal hydroxide, preferably an NaOH aqueous solution is mixed with the aqueous solution of the activated silica. Here, a particle size, a shape and a particle size distribution of the silica can be adjusted by temperature, time, a ratio of SiO₂/Na₂O, and so on. For example, by stirring the aqueous solution of the activated silica for 1 minute to 12 hours at the temperature of 60 to 150 °C after adding the NaOH aqueous solution, an aqueous sol in which the silica particles are grown to have an average particle size of about 5 to 30 nm and stabilized can be obtained. Subsequently, by letting this aqueous sol through a porous film to remove water, a silica sol in which SiO₂ concentration is heightened can be obtained.

Metal compound ions in the silica sol prepared as described above are removed by ion exchange (Fig. 1(B)). For example, by contacting the silica sol with a cation exchange resin in hydrogen form, metal impurity ions, particularly heavy metal ions such as Cu, Fe and Ni on the surfaces of the silica particles or in the solution can be effectively removed. Additionally, since not only the metal impurity ions but also alkali metal ions such as Na are removed by this ion exchange, a pH of the silica sol changes toward the acid side. It is preferable that this ion exchanged silica sol is an acid silica sol (I) having a pH in the range of 2 to 4 (Fig. 1(C)).

Subsequently, the ion exchanged silica sol is purified further (Fig. 1(D)). As a means of such a purifying, for example, ion exchange can be carried out again. Namely, by carrying out ion exchange again, it becomes possible that metal impurity ions, particularly heavy metal ions such as Cu left on the surfaces of the silica particles or in the solution in minuscule quantities are removed all the more and the silica sol is purified further.

It is preferable that the silica sol after the purifying step is also an acid silica sol (II) having a pH in the range of 2 to 4 (Fig. 1(E)).

Subsequently, alkali metal hydroxide is added to the silica sol purified as described above (Fig. 1(F)). For example, an NaOH aqueous solution having high purity is added to raise a pH of the silica sol close to the range of 8 to 14. By making the silica sol strong alkaline like this, it becomes possible to improve its etching effect. KOH and the like can be used as the alkali metal hydroxide.

Then, as the last step, an acid is added to the silica sol to which the alkali metal hydroxide is added as described above (Fig. 1(G)). It is preferable that a strong acid is used as the acid added here. For example, inorganic acids such as hydrochloric acid, sulfuric acid and nitric acid are preferably used. Although actions and advantages caused by addition of such a strong acid have not been made clear, it is considered that when a strong acid is added, metal impurities in a wafer can be reduced through such a mechanism as follows.

As the silica sol before the acid is added is alkaline, metal impurities and so on are present in the form of metal hydroxides (for example, Cu(OH)₂, Ni(OH)₂). Since these metal hydroxides are positively charged, they are firmly adsorbed on surfaces of silica particles (a colloidal silica) that are negatively charged. Therefore, it is considered that when a silicon wafer is polished using a polishing agent containing such silica particles, metal impurities adsorbed on the surfaces of the silica particles may become a cause for metal contamination. And, it is considered that if these metal hydroxides are kept away from the surface of the colloidal silica, the metal contamination can be reduced.

Then, when a strong acid, for example, sulfuric acid is added, as sulfuric acid is more acidic than silica, it strips the metal hydroxides which are adsorbed on the surfaces of the silica particles, and is firmly adsorbed on the surfaces of the silica particles. As a result, addition of a strong acid provides an effect of keeping metal hydroxides away from the surfaces of the silica particles, so that it is considered that the metal contamination of the wafer can be suppressed.

Furthermore, not only the strong acid as described above but a weak acid such as phosphoric acid can be used. Moreover, using carboxylic acids such as acetic acid, formic acid, oxalic acid, tartaric acid and benzoic acid, or organic acids such as sulfamic acid also can provide the effect of reducing Cu and the like. Alternatively, a mixed acid of the acids as described above also can be used.

Furthermore, in this step, it is preferable that quaternary ammonium salt, particularly, tetramethylammonium hydroxide (TMAH) is added together with the acid (Fig. 1(G)). Moreover, if the TMAH is directly added to an acid silica sol, it is feared that the silica sol mixed with the TMAH becomes thickened due to a problem concerning stability of compatibility. Accordingly, for example, given quantity of NaOH having high purity is added in advance until a pH of the silica sol becomes about 8.5, then, sulfuric acid and the TMAH are added together. By adding the TMAH like this, agglomeration of the silica particles can be prevented and the polishing agent can be stabilized. Furthermore, tetraethylammonium hydroxide (TEAH), methyltriethylammonium hydroxide, tetrapropylammonium hydroxide, tetrabutylammonium hydroxide, methyltributylammonium hydroxide, cetyltrimethylammonium hydroxide, choline, trimethylbenzylammonium hydroxide and so on are mentioned as the quaternary ammonium salt that is added.

Moreover, the quaternary ammonium salt as described above can be added either before or after the acid is added after the alkali metal hydroxide is added.

Further, an organic chelating agent such as amine salt, ethylenediamine can be added as occasion demands (Fig. 1(G)). Polyamino-polycarboxylic acid derivatives and salts of polyamino-polycarboxylic acid derivatives can be preferably used as the organic chelating agent. Specifically, at least one out of nitrilotriacetic acid (NTA), hydroxyethyliminodiacetic acid (HIDA), ethylenediaminetetraacetic acid (EDTA), hydroxyethylethylenediaminetriacetic acid (EDTA-OH), 1,3-diaminopropanetetraacetic acid (DPTA), diethylenetriaminepentaacetic acid (DTPA), triethylenetetraminehexaacetic acid (TTHA), 2-hydroxy-1,3-diaminopropanetetraacetic acid (DPTA-OH), nitrilotrimethylenephosphonic acid (NTMP), nitrilotriethylenephosphonic acid (NTEP), ethylenediaminetetramethylenephosphonic acid (EDTMP), ethylenediaminetetraethylenephosphonic acid (EDTEP), diethylenetriaminepentamethylenephosphonic acid (DTPMP), diethylenetriaminepentaethylenephosphonic acid (DTPEP), triethylenetetraminehexamethylenephosphonic acid (TTHMP) and triethylenetetraminehexaethylenephosphonic acid (TTHEP) can be added.

Also the organic chelating agent as described above can be added together with the acid such as sulfuric acid, or can be added either before or after the acid is added after the alkali metal hydroxide is added. When such an organic chelating agent is added, the chelating agent captures metal ions such as Cu, so that the metal contamination of a wafer can be suppressed.

Moreover, either of the quaternary ammonium salt and the organic chelating agent as described above, or both of the two can be added.

However, in all cases, it is preferable that in the end, the silica sol after the acid is added has a pH in the range of 10 to 12 (Fig. 1(H)). When the silica sol is alkaline with a pH in this range, it comes to have an adequate etching effect on the silicon wafer and show preferred mechanochemical effects.

Through the steps as described above, it is possible to remove metal impurities adsorbed on surfaces of silica particles, by adding an acid, particularly a strong acid such as sulfuric acid in the final stage without adding aluminate and without carrying out a heat sterilization treatment. Furthermore, since all that required is carrying out a purifying treatment by ion exchange and the like plural times with making almost no change to steps of producing silica particles themselves, it becomes possible to prevent the silica particles from being distorted, so that the silica particles can have the same shape as conventional ones. Therefore, a polishing agent of high quality in which the surfaces of the silica particles have extremely high purity and a particle shape is spherical can be produced.

Next, there will be explained a case where a surface of a silicon wafer is polished using the polishing agent produced by the method as described above.

A polishing apparatus is not particularly limited. For example, a single-side polishing apparatus 1 as shown in Fig. 2 can be used. When a silicon wafer W is polished, the wafer W is held with a polishing head 2, then, a polishing turn table 3 and the polishing head 2 are respectively rotated in given directions. A polishing pad 4 is provided with a polishing agent 6 through a nozzle 5 in a given flow rate, and the wafer W is held against the polishing pad 4 under a given load. Thereby, the wafer W is contacted and rubbed with the polishing pad 4 with the polishing agent intervening between the wafer W and the polishing pad 4, and silica particles contained in the polishing agent contact with a surface of the wafer W along with etching due to being alkaline, then the polishing progresses. Here, in the present invention, the polishing pad is provided with the polishing agent produced by the method in the present invention.

As described above, when the wafer is polished with the polishing agent in the present invention provided in a polishing step, metal contamination of the wafer W due to the polishing agent can be extremely effectively prevented, for there are few metal impurities attaching to the surfaces of the silica particles. Furthermore, in the polishing agent produced by the present invention, since the silica particles are not distorted and almost spherical, an extraordinary high incidence of LPDs of the wafer will not be brought about. Accordingly, a mirror silicon wafer having high flatness in which metal contamination such as Cu is extremely suppressed can be produced.

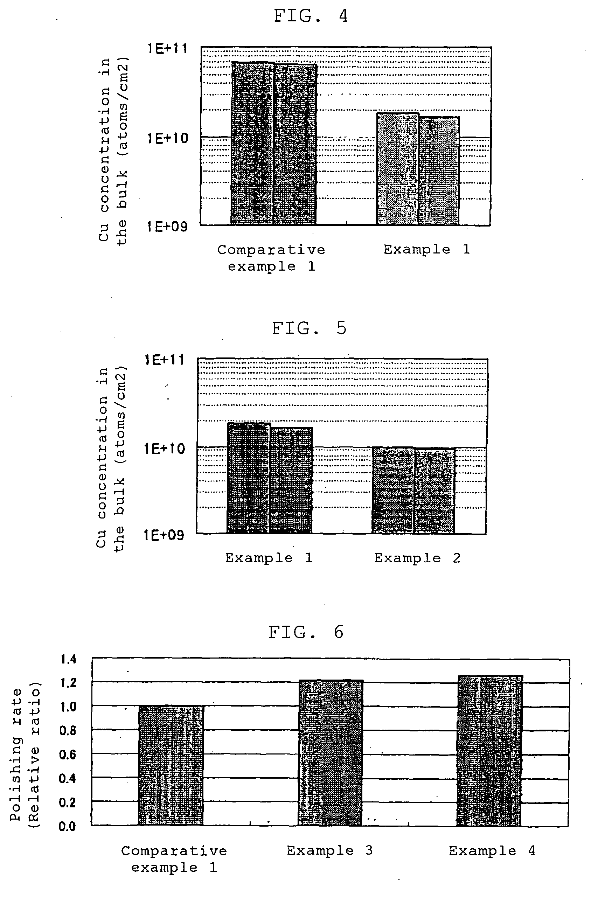

Moreover, the polishing can be carried out using a double-side polishing apparatus. For example, in a double-side polishing apparatus 11 as shown in Fig. 3, a wafer W held in a holding hole of carrier 12 is sandwiched between polishing pads 14a and 14b that are respectively attached on a upper turn table 13a and a lower turn table 13b, then the both sides of the wafer w are polished at the same time. In this case, by providing the polishing agent in the present invention through a polishing agent-providing hole 15 formed in the upper turn table 13a, a silicon wafer of high quality having high flatness in which metal contamination is extremely suppressed can be produced.

Hereinafter, Examples of the present invention and Comparative examples will be explained.

### (Example 1)

Ion exchange was carried out on an alkaline silica sol having a pH of 10 (average particle size: about 11 nm) using a column filled with a cation exchange resin in hydrogen form, and ion exchange was carried out again so that the silica sol could be purified further. By carrying out the ion exchange twice, there was obtained an acid silica sol having a pH of 2.5. Next, an NaOH aqueous solution having high purity was mixed to increase the pH to 12, then phosphoric acid was added to provide a polishing agent (pH 11.5).

A silicon wafer was polished using the polishing agent thus produced. As the silicon wafer, a silicon wafer (CW) of P-type having a diameter of 200 mm, crystal axis of <100> and resistivity of 0.01 ~ 0.1 Ωcm, that had been etched after being lapped was used. The polishing was carried out with a single-side polishing apparatus as shown in Fig. 2 with it divided into three steps, the first step, the second step and a final step. Stock removal was about 10 µm in total.

After the polished wafer was subjected to SC1 cleaning and SC2 cleaning, a Cu concentration in the bulk of the wafer was measured. The Cu concentration was measured in a way in which concentrated sulfuric acid was dropped on the surface of the silicon wafer so that solid-solute metal impurities in the wafer were extracted in the concentrated sulfuric acid, then Cu in the concentrated sulfuric acid was measured with a frameless Atomic Absorption Spectrometer (AAS) (see Japanese Patent Laid-Open (kokai) No.2001-208743). The measurement of the Cu concentration was carried out on two wafers.

### (Comparative example 1)

Ion exchange was carried out once on an alumina-coated silica sol to provide a polishing agent. A silicon wafer was polished using this polishing agent. Polishing and cleaning were carried out under the same condition as Example 1 other than the polishing agent, then a Cu concentration in the bulk of the wafer was measured in the same manner as Example 1.

The measurement results of the Cu concentration in Example 1 and Comparative example 1 are shown in Table 1 and Fig. 4.

**<Table 1>**

| | Alumina coat | Ion exchange | Added acid | Cu concentration in the bulk (atoms/cm²) | |
|---|---|---|---|---|---|
| Example 1 | Absent | Twice | phosphoric acid | 1.83E+10 | 1.65E+10 |
| Comparative Example 1 | Present | Once | None | 6.77E+10 | 6.40E+10 |

As is obvious from Table 1 and Fig. 4, it was found that the Cu concentration in the bulk is 2E + 10 or less in Example 1, which is one-third of that in Comparative example 1.

### (Example 2)

Ion exchange was carried out on an alkaline silica sol (average particle size: about 11 nm) in the same manner as Example 1, and ion exchange was carried out again so that the silica sol could be purified further. Next, an NaOH aqueous solution having high purity was mixed, then sulfuric acid was added to produce a polishing agent (pH 11).

A silicon wafer was polished using this polishing agent. Polishing and cleaning were carried out under the same condition as Example 1 other than the polishing agent, then a Cu concentration in the bulk of the wafer was measured.

The Cu concentration in the bulk measured in Example 2 is shown in Table 2 and Fig. 5 together with the measurement result of Example 1.

**<Table 2>**

| | Alumina coat | Ion exchange | Added acid | Cu concentration in the bulk (atoms/cm²) | |
|---|---|---|---|---|---|
| Example 1 | Absent | Twice | phosphoric acid | 1.83E+10 | 1.65E+10 |
| Example 2 | Absent | Twice | sulfuric acid | 1.00E+10 | 9.50E+09 |

As is obvious from Table 2 and Fig. 5, in Example 2 in which sulfuric acid was added, the Cu concentration in the bulk was 1E + 10 or less, from which it was found that the polishing agent of Example 2 had even higher degree of effectiveness in suppressing Cu contamination than that of Example 1 in which phosphoric acid was added.

### (Examples 3 and 4)

An NaOH aqueous solution having high purity was mixed after the same steps as Example 2 such as ion exchange, then TMAH was added together with sulfuric acid to produce a polishing agent (pH 11) (Example 3).

Moreover, TMAH was added together with sulfuric acid through the same steps as Example 3, then 2-hydroxy-1,3-diaminopropanetetraacetic acid was added as an organic chelating agent to produce a polishing agent (Example 4).

As for each of Examples 3, 4, the number of ion exchanges, the presence or absence of an added acid and a chelating agent, and so on are shown in Table 3, together with those of the polishing agent of Comparative example 1.

**<Table 3>**

| | Alumina coat | Ion exchange | Added acid | Chelating agent |
|---|---|---|---|---|
| Comparative Example 1 | Present | Once | None | None |
| Example 3 | Absent | Twice | sulfuric acid | None |
| Example 4 | Absent | Twice | sulfuric acid | 2-hydroxy-1,3-diaminopropanetetraacetic acid |

A silicon wafer was polished using the polishing agents of Examples 3 and 4 respectively. Polishing and cleaning were carried out under the same condition as Example 1 other than the polishing agents, then a polishing rate, the number of defects on the surface of the wafer and a Cu concentration in the bulk were measured.

As for the polishing rate, stock removal was determined with an electrical capacitance instrument for measuring thickness, and the polishing rate was calculated with regarding the average value by the hour in Comparative example 1 as 1.0.

Fig. 6 shows the polishing rate (the average value of that of the two wafers) when each polishing agent was used. It was found that in the case where the polishing agent of Example 3 or 4 was used, the polishing rate was improved by 20% or more, compared with the case where a conventional polishing agent (Comparative example 1) was used. This is considered to be an effect produced by addition of the TMAH.

The numbers of defects on surfaces of the polished wafers were measured with a microscope of laser confocal optics (manufactured by Lasertec Corporation: MAGICS).

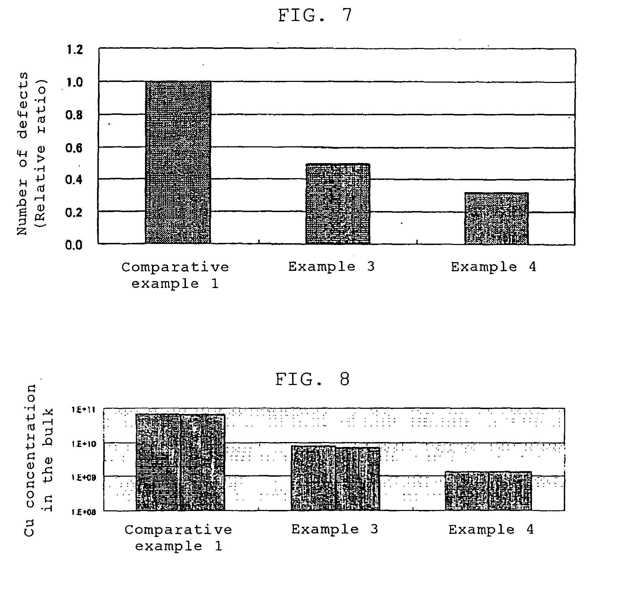

Fig. 7 shows the numbers of defects on the surfaces (the average value of that of the two wafers) when the average value in Comparative example 1 was regarded as 1.0. In the case where the polishing agent of Example 3 or 4 was used, a density of defects on the surface of the polished wafer was half or less than that in the case where the conventional polishing agent (Comparative example 1) was used. Particularly, in the case where the polishing agent of Example 4 in which the chelating agent was added was used, the density was about 30% of that in Comparative example 1.

The Cu concentration in the bulks of the polished wafers was shown in Table 4 and Fig. 8.

**<Table 4>**

| | Cu concentration in the bulk (atoms/cm²) | |
|---|---|---|
| Comparative example 1 | 6.77.E+10 | 6.40.E+10 |
| Example 3 | 7.50.E+09 | 6.80.E+09 |
| Example 4 | 1.40.E+09 | 1.40.E+09 |

In the case where the polishing agent of Example 3 or 4 was used, the Cu concentration in the bulk of the polished wafer was a digit smaller than that in the case where the polishing agent of Comparative example 1 was used, and particularly, in the case where the polishing agent of Example 4 in which the chelating agent was added was used, the Cu concentration became still smaller than that in the case where the polishing agent of Example 3 in which the chelating agent was not added was used, from which it was found that the polishing agent of Example 4 has an extremely high degree of effectiveness in suppressing Cu contamination.

The present invention is not limited to the above-described embodiments. The above-described embodiments are mere examples, and those having the substantially same constitution as that described in the appended claims and providing the similar action and advantages are included in the scope of the present invention.

For example, in the above-described embodiments, the case of polishing a surface of a silicon wafer was explained. However, the polishing agent produced in the present invention can be used for polishing a chamfered portion.

Moreover, a polishing object is not limited to a silicon wafer, and the polishing agent produced in the present invention can be preferably used for polishing various kinds of precision substrates such as other semiconductor wafers or a quartz substrate that are required to prevent metal contamination as well as to have high flatness.

Furthermore, a silicon wafer of low resistance was used in Examples. However, the polishing agent produced in the present invention can be used regardless of resistance of a wafer and provide the same effects not only on reducing metal contamination such as Cu of a polished wafer but also on improving a polishing rate and reducing the number of defects on a surface of a wafer.

## Claims

1. A method for producing a polishing agent in which silica particles are dispersed in an aqueous solution, comprising at least a step of removing metal compound ions from a prepared silica sol by ion exchange; a step of purifying further the ion-exchanged silica sol; a step of adding alkali metal hydroxide to the purified silica sol; and a step of adding an acid to the silica sol to which the alkali metal hydroxide is added.

2. The method for producing a polishing agent according to claim 1, wherein a strong acid is used as the acid.

3. The method for producing a polishing agent according to claim 1 or 2, wherein after the alkali metal hydroxide is added, quaternary ammonium salt is added either together with the acid, or before or after the acid is added.

4. The method for producing a polishing agent according to claim 3, wherein tetramethylammonium hydroxide is used as the quaternary ammonium salt.

5. The method for producing a polishing agent according to any one of claims 1 - 4, wherein after the alkali metal hydroxide is added, an organic chelating agent is added either together with the acid, or before or after the acid is added.

6. The method for producing a polishing agent according to claim 5, wherein at least one selected from the group consisting of polyamino-polycarboxylic acid derivatives and salts of polyamino-polycarboxylic acid derivatives is used as the organic chelating agent.

7. The method for producing a polishing agent according to any one of claims 1 - 6, wherein ion exchange is carried out as the step of purifying.

8. The method for producing a polishing agent according to any one of claims 1 - 7, wherein an alkaline silica sol having a pH in the range of 8 to 13 is used as the prepared silica sol.

9. The method for producing a polishing agent according to any one of claims 1 - 8, wherein a silica sol containing spherical-silica particles having an average particle size in the range of 11 to 13 nm is used as the prepared silica sol.

10. The method for producing a polishing agent according to any one of claims 1 - 9, wherein after the ion exchange is carried out, the silica sol has a pH in the range of 2 to 4.

11. The method for producing a polishing agent according to any one of claims 1 - 10, wherein the silica sol after the acid is added has a pH in the range of 10 to 12.

12. The polishing agent produced by the method according to any one of claims 1 - 11.

13. A method for producing a silicon wafer comprising at least a polishing step, wherein as the polishing step, the wafer is polished by contacting and rubbing with a polishing pad with providing the polishing agent produced by the method according to any one of claims 1 - 11 to the polishing pad.
